# EUROPÄISCHE PATENTSCHRIFT

(11) **EP 0 859 932 B1**
(45) Veröffentlichungstag und Bekanntmachung des Hinweises auf die Patenterteilung: **20.02.2002**
(21) Anmeldenummer: 96945499.0
(22) Anmeldetag: 15.10.1996
(51) Int. Cl.: F21S 8/10, F21V 17/00, B60Q 1/04

(54) **KRAFTFAHRZEUGSCHEINWERFER MIT HOCHDRUCKGASENTLADUNGSLAMPE**
MOTOR VEHICLE HEADLIGHT WITH HIGH-PRESSURE GAS DISCHARGE LAMP
PROJECTEUR DE VEHICULE A MOTEUR A LAMPE A DECHARGE A HAUTE PRESSION

(30) Priorität: 24.11.1995 DE 19543852
(43) Veröffentlichungstag der Anmeldung: 26.08.1998
(73) Patentinhaber: ROBERT BOSCH GMBH, 70442 Stuttgart (DE)
(72) Erfinder: FREY, Martin, D-72805 Lichtenstein (DE); GORILLE, Ingo, D-71739 Oberriexingen (DE)
(86) Internationale Anmeldenummer: DE9601956
(87) Internationale Veröffentlichungsnummer: WO9720168

(56) Entgegenhaltungen:
- DE-A- 4 231 538
- FR-A- 2 704 937
- FR-A- 2 710 131
- GB-A- 2 095 811

## Beschreibung

### Stand der Technik

Die Erfindung geht aus von einem Kraftfahrzeugscheinwerfer mit Hochdruckgasentladungslampe der im Oberbegriff des Anspruchs 1 definierten Gattung.

Bei einem bekannten Kraftfahrzeugscheinwerfer mit Hochdruckgasentladungslampe dieser Art (DE 35 19 611 A1) ist am rückwärtigen Teil des Reflektors ein Formgehäuse vorgesehen. Dieses enthält ein elektronisches, die Lampe mit einer hochfrequenten Zünd- und Brennspannung versorgendes Vorschaltgerät. Die Hochdruckgasentladungslampe ist durch eine Öffnung im Reflektor direkt in das Vorschaltgerät eingesetzt. Zwischen Reflektor und Formgehäuse ist zum Schutz gegen schädliche Einwirkungen von Feuchtigkeit und Korrosion eine elastische Dichtungsmasse eingebracht. Die Versorgung des Vorschaltgeräts mit Spannung erfolgt über ein einfaches Kabelpaar vom Bordnetz des Kraftfahrzeuges.

Bei diesem bekannten Kraftfahrzeugscheinwerfer mit Hochdruckgasentladungslämpe ist das Formgehäuse ausdrücklich als aus Kunststoff bestehend beschrieben. Es dient zusammen mit dem Einbauort direkt am Reflektor dazu, das Vorschaltgerät im Kraftfahrzeug so zu gestalten und anzuordnen, dass es ohne zusätzlich erforderlichen Platzbedarf gegen Witterungseinflüsse geschützt ist, elektrosche Überschläge zu anderen Teilen des Fahrzeugs ausgeschlossen und die hochspannungsführenden Leitungen zur Verringerung kapazitiver Verluste kurz sind.

Dieses aus Kunststoff bestehende Gehäuse für das Vorschaltgerät ist nicht in der Lage, genügend Wärme abzuleiten, die von der Elektronik und der Lampe in seinem Inneren erzeugt wird. Darüberhinaus ist dieses aus Kunsststoff bestehende Gehäuse nicht in der Lage, die von der Elektronik des Vorschaltgeräts in seinem Inneren erzeugten Störstrahlungen am Abstrahlen aus dem Gehäuse heraus zu hindern. Damit sind elektronische Bauteile und Vorrichtungen im Motorraum durch die abgestrählten Störspannungen gefährdet. Somit ist die notwendige elektro-magnetische Verträglichkeit dieser bekannten Anordnung nicht gewährleistet.

Aus der FR 2 704 937 A1 ist ein Kraftfahrzeugscheinwerfer mit Hochdruckgasentladungslampe gemäß dem Oberbergiff des Anspruchs 1 bekannt. Die Lampe ist in einem Reflektor angeordnet, der rückseitig mit einem besonderen Gehäuse so ausgestaltet ist, dass die für den Betrieb der Lampe notwendige Elektronik dort aufgenommen ist. Das an den Reflektor fest angebaute Gehäuse ist wärmeableitend und elektromagnetisch abschirmend ausgestaltet, um die insbesondere von der Elektronik und gegebenenfalls von der Hochdruckgasentladungslampe erzeugte Wärme abzuführen und die auftretende elektromagnetische Strahlung abzuschirmen. Bei dieser bekannten Anordnung ist das die Elektronik aufnehmende Gehäuse ein einziges Bauteil zusammen mit dem Reflektor und dem Kraftfahrzeugscheinwerfergehäuse und ist an dieses baulich speziell angepasst. Dies bedingt, dass für jeden Scheinwerfer bzw. für jedes Lampengehäuse ein separates Bauteil zu entwickeln, zu bauen und zu bevorraten ist. Das Aufwand ist erheblich und die Gestaltung nicht flexibel.

Die der Erfindung zu Grunde liegende Aufgabe besteht somit darin, eine derartige Gestaltung anzugeben, dass Reflektor mit Hochdruckgasentladungslampe einerseits und Gehäuse für die Elektronik andererseits als getrennte Bauteile einfach miteinander zu verbinden.

### Vorteile der Erfindung

Der erfindungsgemäße Kraftfahrzeugscheinwerfer mit Hochdruckgasentladungslampe mit den kennzeichnenden Merkmalen des Anspruchs 1 löst diese Aufgabe demgegenüber in sehr vorteilhafter und einfacher Weise. Die Erfindung bietet den Vorteil, dass jedes Bauteil, also einerseits Reflektor mit Hochdruckgasentladungslampe und andererseits das Gehäuse für die Elektronik unabhängig voneinander gestaltet sein können. Jeweils die Teile des Verschlußmechanismusses, welche die beiden Bauteile miteinander verbindet, sind aufeinander abgestimmt. Außerdem ist durch den erfindungsgemäß vorgesehenen genormten Verschlußmechanismus die Handhabung beim Einbau dadurch einfach und akzeptabel gestaltet und insgesamt die Flexibilität entscheidend erhöht.

Gemäß der Erfindung wird dies dadurch erreicht, dass das Gehäuse mittels eines genormten Verschlussmechanismus, insbesondere einem Bajonettverschluß, am Reflektor befestigbar ist.

Durch die in den weiteren Ansprüchen aufgeführten Maßnahmen sind vorteilhafte Weiterbildungen und Verbesserungen des im Anspruch 1 angegebenen Kraftfahrzeugscheinwerfers möglich.

Gemäß einer besonders vorteilhaften Ausgestaltung der Erfindung besteht das Gehäuse aus Wärme ableitendem Material. In weiterer vorteilhafter Ausgestaltung ist das Gehäuse innen und/oder außen mit einer die elektromagnetische Strahlung der Elektronik oder der Umgebung abschirmenden Beschichtung versehen.

In vorteilhafter alternativer Ausführung kann als Material für das Gehäuse ein solches vorgesehen sein, das neben der Wärmeableitung auch die Funktion der Abschirmung elektromagnetischer Strahlung erfüllt.

Zur intensiveren und sichereren Wärmeableitung ist gemäß einer zweckmäßigen Weiterbildung der Erfindung das Gehäuse zur Wärmeableitung mit die Oberfläche vergrößernden Teilen, insbesondere in Form von Kühlrippen oder dergleichen, versehen.

In weiterer vorteilhafter Ausgestaltung der Erfindung ist die Hochdruckgasentladungslampe entweder auswechselbar oder fest mit dem Gehäuse verbunden.

### Zeichnung

Die Erfindung ist anhand eines in der Zeichnung dargestellten Ausführungsbeispiels in der nachfolgenden Beschreibung näher erläutert. Es zeigt:

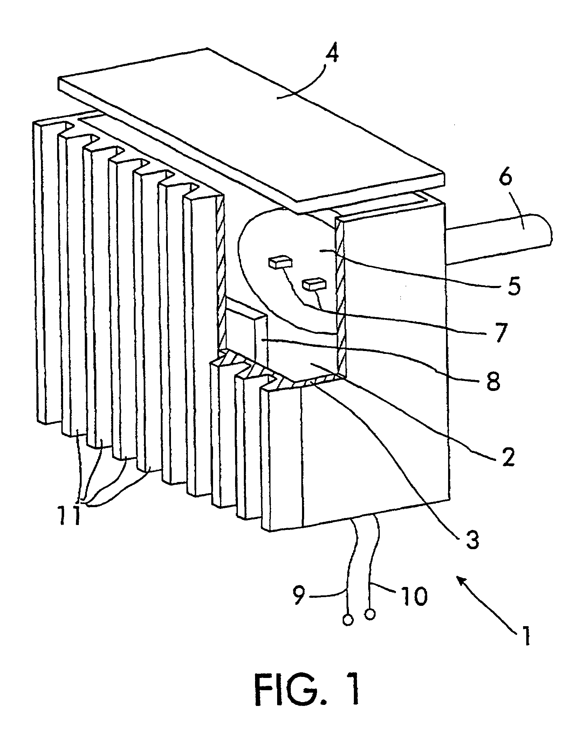

- Fig. 1: schematisch in perspektivischer Ansicht ein erfindungsgemäß gestaltetes Gehäuse, bei dem zum Einblick in das Innere eine Ecke ausgeschnitten ist.

### Beschreibung des Ausführungsbeispiels

In Fig. 1 ist schematisch in perspektivischer Ansicht ein erfindungsgemäß gestaltetes Gehäuse 1 dargestellt, bei dem zum Einblick in das Innere 2 eine Ecke 3 ausgeschnitten ist. Ein Deckel 4 des Gehäuses 1 ist etwas abgehoben dargestellt, um einen Sockel 5 einer Hochdruckgasentladungslampe 6 besser sichtbar zu machen. Im Sockel 5 sind zwei Anschlußstifte 7 angeodnet, in die, innerhalb des Sockels 5 und hier nicht sichtbar , Anschlußelektroden der Hochdruckgasentladungslampe 6 einsetzbar sind. Über die Anschlußstifte 7 wird die Hochdruckgasentladungslampe 6 mit der von einer Elektonik 8, die nur andeutungsweise dargestellt ist, erzeugten elektrischen Energie versorgt, gesteuert und geregelt. Die Elektronik 8 selbst wird über einfache Anschlußkabel 9 und 10, die an geeigneter Stelle in das Gehäuse 1 eingeführt sind, aus der nicht dargestellten Batterie des Kraftfahrzeuges mit Gleichspannung von beispielsweise 12 V versorgt.

Gemäß der Erfindung ist das Gehäuse 1 so ausgestaltet, daß es Wärme ableitet und elektromagnetisch abschirmt. Dadurch wird die, erzeugte Wärme, insbesondere diejenige, die von der Elektronik 8 und ggf. auch von der Hochdruckgasentladungslampe 6 erzeugt wird, abgeführt und die auftretende elektromagnetische Strahlung abgeschirmt. Gemäß einer besonders vorteilhaften Ausgestaltung der Erfindung besteht das Gehäuse 1 aus Wärme ableitendem Material. In weiterer vorteilhafter Ausgestaltung kann das Gehäuse 1 innen oder außen oder sowohl innen als auch außen mit einer Beschichtung versehen sein, welche die elektromagnetische Strahlung der Elektronik 8 oder auch solche Strahlung, die von außen kommt, abschirmt.

In vorteilhafter alternativer Ausführung kann als Material für das Gehäuse 1 ein solches vorgesehen sein, welches neben der Wärmeableitung auch die Funktion der Abschirmung elektromagnetischer Strahlung erfüllt.

Zur intensiveren und sichereren Wärmeableitung ist das Gehäuse 1 mit zur Wärmeableitung mit die Oberfläche vergrößernden Teilen, insbesondere in Form von Kühlrippen 11 versehen.

In weiterer vorteilhafter Ausgestaltung der Erfindung ist die Hochdruckgasentladungslampe 6 entweder auswechselbar oder fest mit dem Gehäuse 1 verbunden. Im Ausführungsbeispiel gemäß Fig. 1 ist der Sockel 5 mit der Hochdruckgasentladungslampe 6 als herausnehmbar gestaltet.

Um die Handhabung des Einbaus einfach und akzeptabel zu gestalten, ist das Gehäuse 1 mittels eines genormten Verschlußmechanismus, insbesondere einem Bajonettverschluß, am Reflektor befestigt. Sowohl dieser Bajonettverschluß als auch der Reflektor sind im in Fig. 1 dargestellten Ausführungsbeispiel nicht gezeigt.

## Patentansprüche

1. Kraftfahrzeugscheinwerfer mit Hochdruckgasentladungslampe (6), die innerhalb eines Reflektors angeordnet ist, mit einer Vorschaltelektronik (8) für den Betrieb der Hochdruckgasentladungslampe (6), mit einem Gehäuse (1) für die Aufnahme der Elektronik (8), das unmittelbar am Reflektor angeordnet ist, wobei das Gehäuse (1) wärmeableitend und elektromagnetisch abschirmend ausgestaltet ist, um die, insbesondere von der Elektronik (8) und gegebenenfalls von der Hochdruckgasentladungslampe (6) erzeugte Wärme abzuführen und die auftretende elektromagnetische Strahlung abzuschirmen, **dadurch gekennzeichnet, daß** das Gehäuse (1) mittels eines genormten Verschlußmechanismus, insbesondere einem Bajonettverschluß, am Reflektor befestigbar ist.

2. Kraftfahrzeugscheinwerfer nach Anspruch 1, **dadurch gekennzeichnet, daß** das Gehäuse (1) aus Wärme ableitendem Material besteht.

3. Kraftfahrzeugscheinwerfer nach Anspruch 2, **dadurch gekennzeichnet, daß** das Gehäuse (1) innen und/oder außen mit einer die elektromagnetische Strahlung der Elektronik (8) oder der Umgebung abschirmenden Beschichtung versehen ist.

4. Kraftfahrzeugscheinwerfer nach Anspruch 2, **dadurch gekennzeichnet, daß** als Material für das Gehäuse (1) ein solches vorgesehen ist, das neben der Wärmeableitung auch die Funktion der Abschirmung elektromagnetischer Strahlung erfüllt.

5. Kraftfahrzeugscheinwerfer nach einem der vorigen Ansprüche, **dadurch gekennzeichnet, daß** das Gehäuse (1) zur Wärmeableitung mit die Oberfläche vergrößernden Teilen, insbesondere in Form von Kühlrippen (11) oder dergleichen, versehen ist.

6. Kraftfahrzeugscheinwerfer nach einem der vorigen Ansprüche, **dadurch gekennzeichnet, daß** mit dem Gehäuse (1) die Hochdruckgasentladungslampe (6) entweder auswechselbar oder fest verbunden ist.

## Claims

1. Motor vehicle headlight with a high-pressure gas discharge lamp (6) which is arranged inside a reflector, having an electronic ballast (8) for operating the high-pressure gas discharge lamp (6), having a housing (1) for holding the electronic system (8), which is arranged directly on the reflector, the housing (1) being configured in a thermally dissipating and electromagnetically screening fashion, in order to dissipate the heat produced, in particular, by the electronic system (8) and, if appropriate, by the high-pressure gas discharge lamp (6), and in order to screen the electromagnetic radiation occurring, **characterized in that** the housing (1) can be fastened on the reflector by means of a standardized closure mechanism, in particular a bayonet lock.

2. Motor vehicle headlight according to Claim 1, **characterized in that** the housing (1) consists of thermally dissipating material.

3. Motor vehicle headlight according to Claim 2, **characterized in that** the housing (1) is provided on the inside and/or outside with a coating which screens the electromagnetic radiation of the electronic system (8) or of the surroundings.

4. Motor vehicle headlight according to Claim 2, **characterized in that** provided as material for the housing (1) is one such that in addition to the thermal dissipation the function of screening electromagnetic radiation is also fulfilled.

5. Motor vehicle headlight according to one of the preceding claims, **characterized in that** for the purpose of thermal dissipation the housing (1) is provided with parts which enlarge the surface, in particular in the form of cooling ribs (11) or the like.

6. Motor vehicle headlight according to one of the preceding claims, **characterized in that** the high-pressure gas discharge lamp (6) is connected to the housing (1) either exchangeably or permanently.

## Revendications

1. Projecteur de véhicule automobile à lampe à décharge de gaz à haute pression (6) montée à l'intérieur d'un réflecteur, qui comporte, en amont, une électronique (8) commandant le fonctionnement de la lampe (6) et logée dans un boîtier (1) monté directement sur le réflecteur, ce boîtier (1) étant configuré pour évacuer la chaleur et étant également blindé électromagnétiquement, de manière que la chaleur produite par l'électronique (8) et éventuellement par la lampe (6) soit évacuée et qu'il soit fait écran au rayonnement électromagnétique produit,
**caractérisé en ce que**
le boîtier (1) peut être fixé au réflecteur par un mécanisme de verrouillage normalisé, en particulier un verrouillage à baïonnette.

2. Projecteur selon la revendication 1,
**caractérisé en ce que**
le boîtier (1) est fait d'un matériau conducteur de chaleur.

3. Projecteur selon la revendication 2,
**caractérisé en ce que**
le boîtier (1) porte, intérieurement et/ou extérieurement, un revêtement faisant écran au rayonnement électromagnétique de l'électronique (8) ou de l'environnement.

4. Projecteur selon la revendication 2,
**caractérisé en ce que**
pour réaliser le boîtier (1) il est prévu un matériau qui, en plus de conduire la chaleur, assure la fonction d'écran par rapport au rayonnement électromagnétique.

5. Projecteur selon l'une quelconque des revendications précédentes,
**caractérisé en ce que**
le boîtier (1) pour évacuer la chaleur, est équipé de parties augmentant sa surface, en particulier des nervures de refroidissement (11) ou analogues.

6. Projecteur selon l'une quelconque des revendications précédentes,
**caractérisé en ce que**
la lampe à décharge à haute pression (6) est amovible, ou solidaire du boîtier (1).
